# EUROPÄISCHE PATENTANMELDUNG

(11) **EP 1 471 385 A1**
(43) Veröffentlichungstag der Anmeldung: **27.10.2004**
(21) Anmeldenummer: 04006470.1
(22) Anmeldetag: 18.03.2004
(51) Int. Cl.: G03F 1/00, G03F 7/20, G02F 2/02

(54) **Anordnung zur Inspektion von Objekten, insbesondere von Masken in der Mikrolithographie**

(30) Priorität: 24.04.2003 DE 10318562
(71) Anmelder: Carl Zeiss SMS GmbH, 07745 Jena (DE)
(72) Erfinder: Scherübl, Thomas, 07745 Jena (DE); Rosenkranz, Norbert, 07629 Reichenbach (DE)
(74) Vertreter: Hampe, Holger

(57) **Zusammenfassung**

Anordnung zur Inspektion von Objekten , insbesondere von Masken in der Mikrolithographie
wobei ein Wandler zur Umwandlung der vom Objekt kommenden Beleuchtungsstrahlung in eine Strahlung größerer Wellenlänge sowie ein Sensor zur Bildaufzeichnung vorgesehen ist und die Lage des Wandlers zur Beleuchtungsstrahlung veränderbar ist und/ oder der Wandler auswechselbar ist . Vorteilhaft kann eine drehbare Anordnung zur Wandlerverstellung und/ oder Auswechslung vorgesehen sein , eine Auswechslung und/ oder Lageveränderung nach Erreichen einer empirisch bestimmten Zeit ausgelöst werden und anhand von Sensoren für das Beleuchtungslicht vor- und hinter dem Wandler die Bestimmung des Auswechsel und/ oder Lageveränderungszeitpunktes erfolgen.

## Beschreibung

Die Beobachtung, Inspektion, Vermessung und Beurteilung immer kleinerer Strukturen mit Hilfe vergrößernder Anordnungen erfordert ein stetig wachsendes Auflösungsvermögen der vergrößernden Anordnungen. Ein Weg, das zu erreichen ist der Einsatz von Strahlung mit kürzeren Wellenlängen.

Dabei sind unter anderem Anordnungen bekannt, bei denen die vergrößernde Anordnung aus zwei Stufen besteht, zwischen denen sich ein Wandler befindet der die kurzwellige Strahlung umwandelt. Dabei werden zur Wandlung von kurzwelliger Strahlung in ultraviolette oder sichtbare Strahlung Szintillatoren eingesetzt( US 5498923).

Zur Wandlung in Elektronen kommen Photokathoden zum Einsatz.

Diese Wandlerschichten oder Wandlerelemente sind insbesondere durch Kontamination und Degradation im Bereich der auftreffenden Strahlung in ihrer Lebensdauer beschränkt.

### Erfinderische Lösung:

Dieses Problem wird erfindungsgemäß dadurch gelöst , dass die geometrische Zuordnung zwischen der zu wandelnden Strahlung und der Wandlerschicht/Wandlerelement geändert wird. Dabei können die Wandlerschichten/Wandlerelemente jeweils aus einem oder mehreren Einzelelementen bestehen.

Wenn Sie aus einem Element bestehen, ist es vorteilhaft, daß dieses so groß ausgebildet ist, daß ein Wechsel des Auftreffortes der Strahlung auf der Fläche des Wandlerelementes möglich ist.

Weiterhin ist ein Wechsel der Elemente vorteilhaft.

Hierbei kann eine vorher gemessene Alterungskurve als Regelgröße für eine Bewegung oder den Wandlerwechsel dienen.

Ein zeitlicher Schwellwert auf der Kurve ( deutliche Abnahme der durchgelassenen Strahlung) kann als Richtgröße für die Auslösung des Bewegungsvorganges oder Wechselvorganges dienen.

Weiterhin kann für die Strahlungsquelle ein Sensor vorgesehen sein und dessen Signal mit dem Signal eines zweiten Sensors hinter dem Wandlerelement, der auch die Inspektionskamera selbst sein kann, beispielsweise durch Quotientenbildung oder Differenzbildung verglichen werden und hier bei Erreichen eines Schwellwertes ein Bewegungs- oder Wechselvorgang ausgelöst werden.

Der Sensor für die Strahlungsquelle kann vorteilhaft außerhalb des Teiles des Strahlungskegels liegen, der auf das Wandlerelement bzw. eine Übertragungsoptik gelangt.

Die Änderung der geometrischen Zuordnung kann zum Beispiel entsprechend einer der nachfolgend aufgeführten Möglichkeiten erfolgen
- Änderung der Zuordnung in diskreten Zeitintervallen durch Verschieben oder Wechsel.
- Kontinuierliche Änderung der Zuordnung durch ständiges langsames Verschieben
- Änderung der Zuordnung durch Verschieben in einer Koordinatenrichtung in der Ebene der Wandlerschicht/ des Wandlerelement
- Änderung der Zuordnung durch Verschieben in beiden Koordinatenrichtungen in der Ebene der Wandlerschicht/ des Wandlerelement
- Änderung der Zuordnung durch Drehen in der Ebene der Wandlerschicht/Wandlerelement

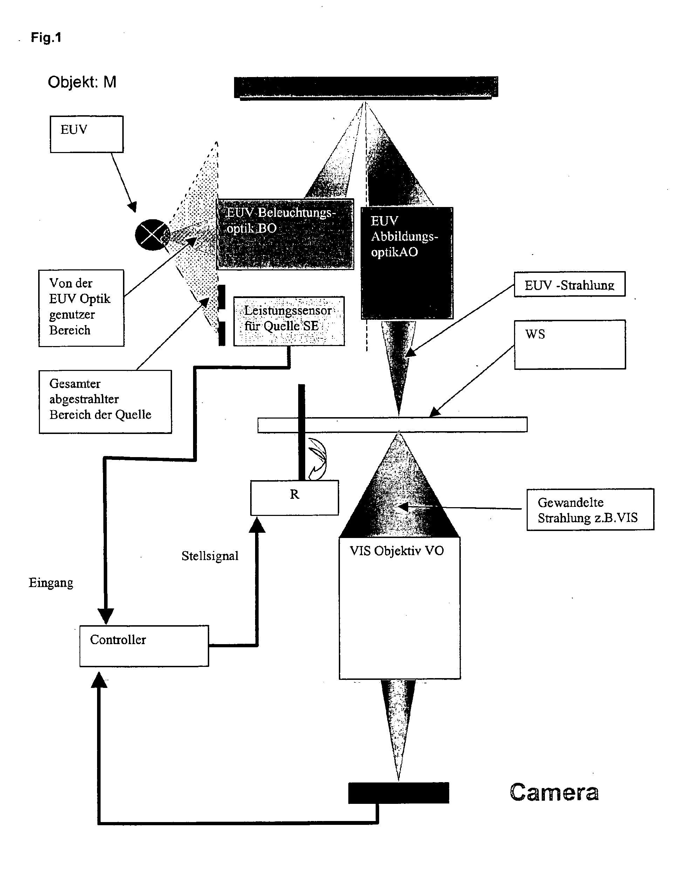

Fig. 1 zeigt schematisch ein System zur Inspektion mittels EUV Strahlung.
Von einer EUV Lichtquelle kommendes Licht wird mittels einer Beleuchtungsoptik BO , vorzugsweise einem Spiegelsystem, auf eine zu untersuchende Maske M abgelenkt. Von dieser Maske refkelktiertes Licht gelangt über eine Abbildungsoprik AO auf eine Wandlerschicht WS und wird auf der anderen Seite des Wandlers über ein Objektiv VO , das für sichtbares Licht ausgebildet ist, auf eine CCD Kamera abgebildet. Außerhalb des Erfassungsbereiches der Beleuchtungsoptik BO ist ein Leistungssensor SE für die Lichtquelle vorgesehen , dessen Meßsignal mit dem Intensitätssignal der CCD Kamera ins Verhältnis gesetzt wird, um die optische Qualität der Wandlerschicht WS zu beurteilen.

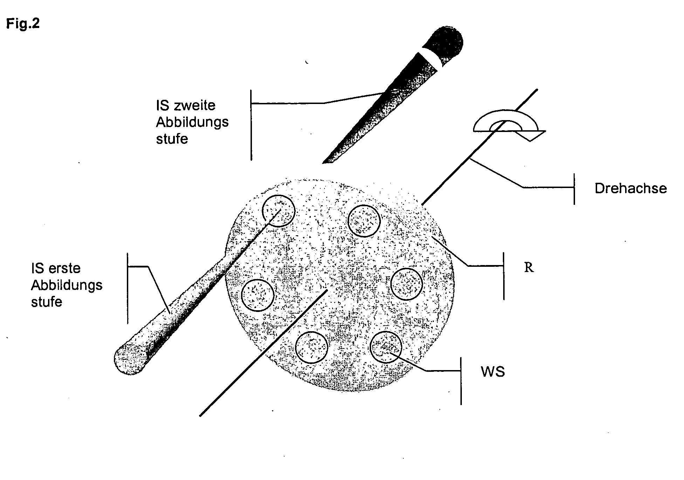

Fig.2 zeigt beispielhaft den auch in Fig.1 dargestellten Revolver R, auf dem sich Wandlerschichten WS , hier mehrere in einem Kreis angeordnete, befinden.
Hier kann eine Auswechslung der im Inspektionsstrahlengang IS befindlichen Wandlerschicht durch Drehung des Revolvers erfolgen.
Sind die Wandler WS größer als dargestellt ausgebildet, kann auch eine kleine Drehung zur 'Änderung des Durchgangsortes auf ein- und demselben Element WS erfolgen.

Weiterhin ist denkbar, die Drehachse DR des Revolvers R senkrecht zum Strahlengang IS erfolgen und dadurch der Ort des Strahlungsdurchganges geändert werden.

## Patentansprüche

1. Anordnung zur Inspektion von Objekten , insbesondere von Masken in der Mikrolithographie
wobei ein Wandler zur Umwandlung der vom Objekt kommenden Beleuchtungsstrahlung in eine Strahlung größerer Wellenlänge vorgesehen ist sowie ein Sensor zur Bildaufzeichnung vorgesehen ist,
wobei die Lage des Wandlers zur Beleuchtungsstrahlung veränderbar ist und/ oder der Wandler auswechselbar ist.

2. Anordnung nach Anspruch 1,
wobei eine drehbare Anordnung zur Wandlerverstellung und/ oder Auswechslung vorgesehen ist.

3. Anordnung nach Anspruch 1 oder 2,
wobei eine Auswechslung und/ oder Lageveränderung nach Erreichen einer empirisch bestimmten Zeit ausgelöst wird.

4. Anordnung nach Anspruch 1,2 oder 3,
wobei anhand von Sensoren für das Beleuchtungslicht vor- und hinter dem Wandler zur Bestimmung des Auswechsel und/ oder Lageveränderungszeitpunktes vorgesehen ist.
